# EUROPEAN PATENT APPLICATION

(11) **EP 1 954 110 A1**
(43) Date of publication of application: **06.08.2008**
(21) Application number: 06833035.6
(22) Date of filing: 21.11.2006
(51) Int. Cl.: H05K 3/34, B23K 1/002, B23K 31/02, H01L 21/52

(54) **SOLDERING APPARATUS AND SOLDERING METHOD**

(30) Priority: 22.11.2005 JP 2005337678
(71) Applicant: KABUSHIKI KAISHA TOYOTA JIDOSHOKKI, Kariya-shi, Aichi 448-8671 (JP)
(72) Inventor: KIMBARA, Masahiko, Kariya-shi Aichi 448-8671 (JP)
(74) Representative: TBK-Patent
(86) International application number: PCT/JP2006/323185
(87) International publication number: WO 2007/060936

(57) **Abstract**

A soldering apparatus has a sealable container which accommodates a circuit board therein, weights disposed immediately upon semiconductor devices to press the semiconductor devices toward the circuit board, and high-frequency heating coils causing the weight to generate heat due to electromagnetic induction. The high-frequency heating coils are disposed away from the weights. The heat generated in each weight is applied to a plurality of joint sites of the circuit board, thereby soldering the semiconductor devices to the joint sites. As a result, efficient heating is realized while simplifying the configuration of the apparatus.

## Description

### TECHNICAL FIELD

The present invention relates to a soldering apparatus and a soldering method for soldering a semiconductor device onto a circuit board.

### BACKGROUND ART

Conventionally, as methods for joining a metal member to a ceramic member or a board to an electronic component, for example, methods using high-frequency induction heating as disclosed in Patent Documents 1, 2 and 3 are known. High-frequency induction heating is phenomenon that when a conductor is placed in a coil through which a high-frequency current flows, the conductor generates heat due to electromagnetic induction. In apparatuses disclosed in Patent Document 1 and Patent Document 2, a high-frequency heating coil is disposed so as to enclose the conductor member (iron core or pressure jig). Heat generated in the conductor member melts solder to join the members to each other. Pressurizing a joint surface at the time of joining provides good joint state. Accordingly, in the joining apparatuses disclosed in Patent Document 1 and Patent Document 2, the conductor member functions as a heating element as well as a pressurizing element. In Patent Document 3, a heating element fixed to a holding plate generates heat due to high-frequency induction heating. Heat generated in the heating element is applied to an electrode of an electronic component, thereby melting solder and joining the members to each other.

In a semiconductor module, a plurality of small semiconductor devices are densely disposed on a circuit board. Application of the art disclosed in Patent Document 1 and Patent Document 2 to the soldering apparatus for joining the plurality of semiconductor devices onto the circuit board is very difficult for the following reasons. That is, it is required to provide the conductor members each acting as the heating element and the pressurizing element which correspond to each of the plurality of small semiconductor devices, and enclose each of the conductor members with a high-frequency heating coil. In addition, the high-frequency heating coil used for high-frequency induction heating has a channel through which cooling water for cooling the coil flows therein. For this reason, when the art disclosed in Patent Document 1 and Patent Document 2 is applied to the soldering apparatus for the semiconductor module, the configuration of the soldering apparatus becomes complicated and thus, such application is practically difficult.

After solder is melted, the melted solder is solidified through cooling process to join the semiconductor devices to the circuit board. To obtain good joint state of the semiconductor devices in this cooling process, the semiconductor devices are desirably pressurized by the conductor member (pressurizing element) in cooling the solder. For this reason, with the configuration in which the high-frequency heating coil is provided around the pressurizing element as in Patent Documents 1, 2, the high-frequency heating coil cannot be used until the cooling process is finished. This leads to lowering of operating efficiency.

Preferably, soldering of the semiconductor devices (transistor or diode) to the circuit board is performed in, for example, atmosphere of inert gas. In this case, the atmosphere needs to be adjusted during the soldering operation. However, although Patent Document 3 discloses that the solder is melted by heating a particular point (electrode) of the electronic component, it does not disclose that the soldering operation is performed while adjusting the atmosphere of inert gas. Thus, the art disclosed in Patent Document 3 can hardly be a suitable art to solder the semiconductor devices to the board. Furthermore, it is conceivable that the high-frequency heating coil may be disposed in atmosphere of inert gas in Patent Document 3 as in the art disclosed in Patent Document 2 to adjust the atmosphere. In this case, however, the high-frequency heating coil is disposed in a container which encapsulates the inert gas therein, leading an increase of the container and the soldering apparatus in size as well as wasting of the inert gas.
Patent Document 1: Japanese Laid-Open Patent Publication No. 59-207885
Patent Document 2: Japanese Laid-Open Utility-Model Publication No. 5-13660
Patent Document 3: Japanese Laid-Open Patent Publication No. 8-293668

### DISCLOSURE OF THE INVENTION

An objective of the present invention is to provide a simplified soldering apparatus capable of performing efficient heating, and a soldering method capable of performing an efficient soldering operation.

To attain the above-mentioned object, according to an aspect of the present invention, a soldering apparatus for soldering a semiconductor device to each of a plurality of joint sites of a circuit board. The soldering apparatus includes a sealable container. In the state where the semiconductor devices are placed on the plurality of the joint sites of the circuit board via a solder, the circuit board is accommodated in the container. The soldering apparatus includes a pressurizing element made of a conductor material. The pressurizing element is placed immediately upon the semiconductor devices so as to press the semiconductor devices toward the circuit board. The soldering apparatus includes a high-frequency heating coil disposed away from the pressurizing element. When a high-frequency current is passed to the high-frequency heating coil, the high-frequency heating coil allows the pressurizing element to generate heat due to electromagnetic induction, thereby heating and melting the solder.

According to another aspect of the present invention, a soldering method for soldering a semiconductor device to each of a plurality of joint sites of a circuit board is provided. Soldering method includes steps of: accommodating the circuit board in a sealable container; placing the semiconductor device on each of a plurality of the joint sites of the circuit board via a solder; placing a pressurizing element immediately upon the semiconductor devices to press the semiconductor devices toward the circuit board; in the state where the circuit board on which the semiconductor devices and the pressurizing element are placed is accommodated in the container, sealing the container; disposing the high-frequency heating coil away from the pressurizing element; and passing a high-frequency current to the high-frequency heating coil so as to allow pressurizing element to generate heat due to the electromagnetic induction, thereby heating and melting the solder.

According to still another aspect of the present invention, a method for manufacturing a semiconductor apparatus having a circuit board and semiconductor devices soldered to a plurality of joint sites of the circuit board is provided. The manufacturing method includes steps of: accommodating the circuit board in a sealable container; placing the semiconductor device on each of a plurality of the joint sites of the circuit board via a solder; placing a pressurizing element immediately upon the semiconductor devices to press the semiconductor devices toward the circuit board; in the state where the circuit board on which the semiconductor devices and the pressurizing element are placed is accommodated in the container, sealing the container; disposing the high-frequency heating coil away from the pressurizing element; and passing a high-frequency current to the high-frequency heating coil so as to allow pressurizing element to generate heat due to the electromagnetic induction, thereby heating and melting the solder.

### BRIEF DESCRIPTION OF DRAWINGS

Fig. 1 is a plan view of a semiconductor module in accordance with one embodiment of the present invention;
Fig. 2 is a cross-sectional view taken along a line 2-2 in Fig. 1;
Fig. 3 is a longitudinal cross-sectional view of a soldering apparatus for soldering to the semiconductor module in Fig. 1;
Fig. 4(a) is a plan view of a jig used for the soldering apparatus in Fig. 3;
Fig. 4(b) is a perspective view of a weight used for the soldering apparatus in Fig. 3; and
Fig. 5 is a schematic view showing an arrangement of high-frequency heating coils on the semiconductor module.

### BEST MODE FOR CARRYING OUT THE INVENTION

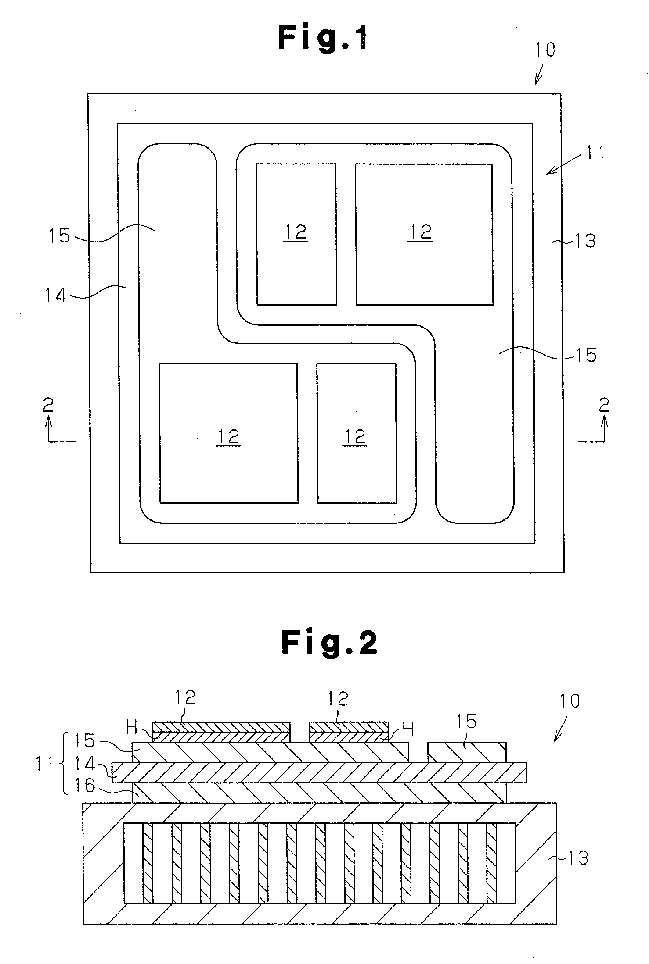

An embodiment of the present invention will be described with reference to Fig. 1 to Fig. 5.

Fig. 1 and Fig. 2 show a semiconductor module 10 as a semiconductor apparatus. The semiconductor module 10 has a circuit board 11, a plurality of (four in this embodiment) semiconductor devices 12 joined to the circuit board 11 and a heat sink 13 as a radiator. The circuit board 11 is formed by joining metal plates 15, 16 to both surfaces of a ceramic substrate 14, respectively. The ceramic substrate 14 is made of, for example, aluminum nitride, alumina or silicon nitride. The metal plate 15 functions as a wiring layer and is made of, for example, aluminum or copper. The semiconductor devices 12 are joined (soldered) to the metal plate 15. Sign "H" in Fig. 2 represents a solder layer. The semiconductor devices 12 include IGBT (Insulated Gate Bipolar Transistor) and diode. The metal plate 16 functions as a joint layer for joining the ceramic substrate 14 to the heat sink 13 and is made of, for example, aluminum or copper. The heat sink 13 is joined to the metal plate 16.

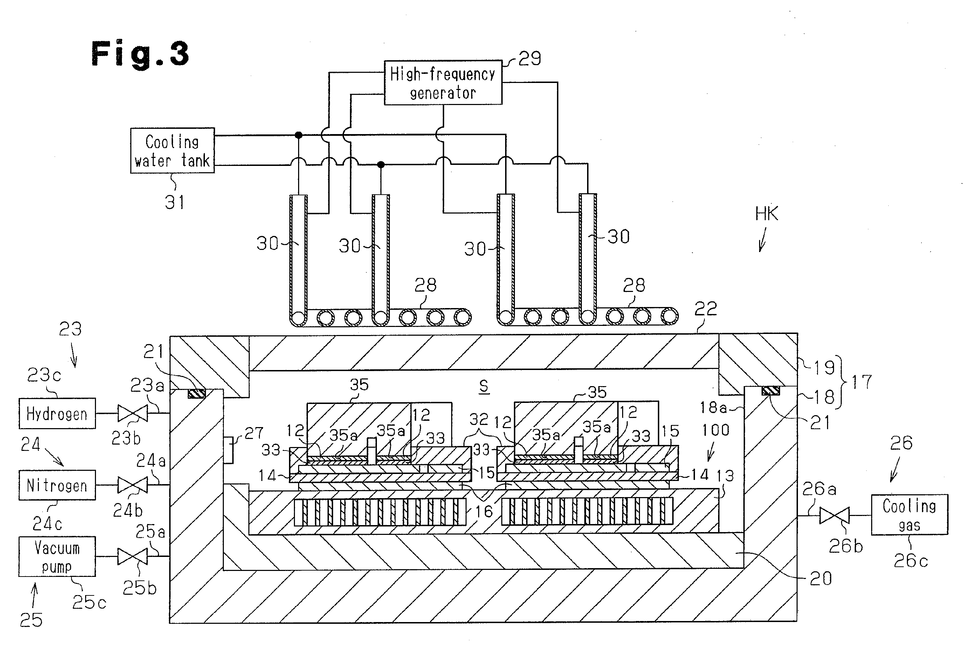

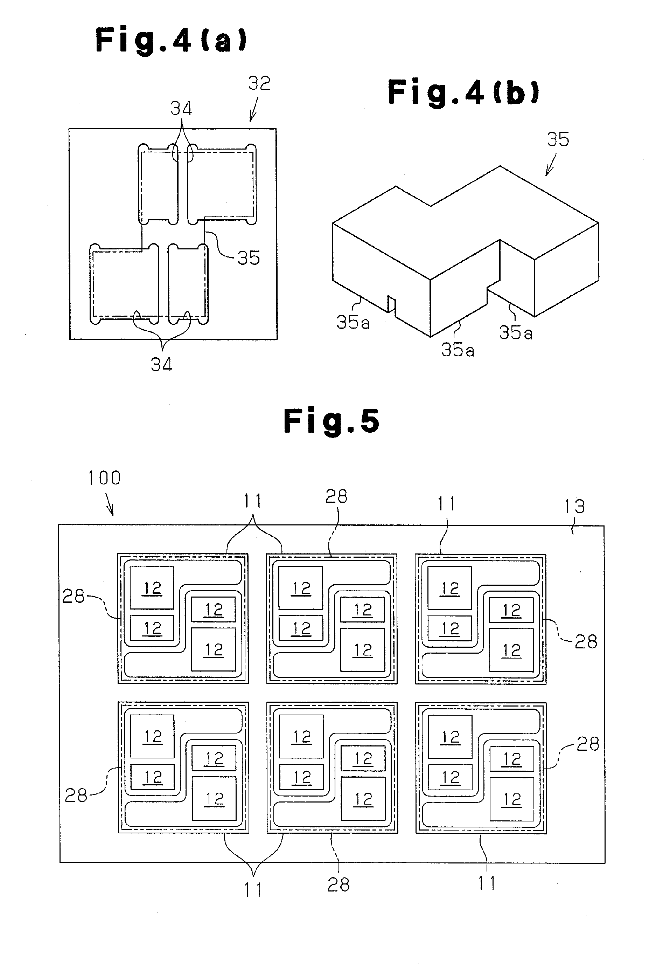

Fig. 3 schematically shows the configuration of a soldering apparatus HK in this embodiment. The soldering apparatus HK is an apparatus for soldering the semiconductor devices 12 to the circuit board 11 (metal plate 15). The soldering apparatus HK in this embodiment is, as shown in Fig. 5, an apparatus for soldering onto a semiconductor module 100 as a semiconductor apparatus containing six circuit boards 11. Accordingly, twenty-four semiconductor devices 12 are soldered to the semiconductor module 100. In the semiconductor module 100 shown in Fig. 5, six heat sinks 13 of the semiconductor modules 10 shown in Fig. 1 are formed as one unit. Six circuit boards 11 are installed on the heat sink 13 formed as one unit.

The soldering apparatus HK has a sealable container (chamber) 17. The container 17 includes a box-like body member 18 having an opening 18a and a lid member 19 for opening or closing the opening 18a of the body member 18. The body member 18 is provided with a support base 20 for positioning and supporting the semiconductor module 100. A packing 21 which can be in close contact with the lid member 19 is provided on the rim of the opening of the body member 18.

The lid member 19 is sufficiently large to close the opening 18a of the body member 18. A closed space S is formed in the container 17 by attaching the lid member 19 to the body member 18. The lid member 19 has a part 22 opposed to the closed space S and the part 22 is formed of an electrical insulating material which can penetrate lines of magnetic force (magnetic flux). In this embodiment, glass is used as the electrical insulating material and the part 22 of the lid member 19 is formed of a glass plate 22.

The body member 18 is connected to a reducing gas supply unit 23 for supplying reducing gas (hydrogen in this embodiment) into the container 17. The reducing gas supply unit 23 has a pipe 23a, an on-off valve 23b provided at the pipe 23a and a hydrogen tank 23c. The body member 18 is also connected to an inert gas supply unit 24 for supplying inert gas (nitrogen in this embodiment) into the container 17. The inert gas supply unit 24 has a pipe 24a, an on-off valve 24b provided at the pipe 24a and a nitrogen tank 24c. The body member 18 is also connected to a gas discharge unit 25 for discharging gas filled in the container 17 to the outside. The gas discharge unit 25 has a pipe 25a, an on-off valve 25b provided at the pipe 25a and a vacuum pump 25c. Since the soldering apparatus HK has the reducing gas supply unit 23, the inert gas supply unit 24 and the gas discharge unit 25, the pressure in the closed space S can be adjusted. That is, the pressure in the closed space S can be increased or decreased.

The body member 18 is also connected to a supply unit (heat medium supply unit) 26 for supplying heat medium (cooling gas) into the container 17 following the soldering operation. The heat medium supply unit 26 has a pipe 26a, an on-off valve 26b provided at the pipe 26a and a gas tank 26c. The heat medium supply unit 26 supplies the cooling gas to the heat sink 13 of the semiconductor module 100 accommodated in the container 17. The heat medium supplied from the heat medium supply unit 26 may be cooling liquid. The body member 18 is provided with a temperature sensor (for example, thermocouple) 27 for measuring the temperature in the container 17.

A plurality of high-frequency heating coils 28 are provided in an upper part of the soldering apparatus HK, specifically, above the lid member 19. The soldering apparatus HK in this embodiment has six high-frequency heating coils 28. As shown in Fig. 5, these high-frequency heating coils 28 are disposed on the circuit boards 11 so as to correspond to six circuit boards 11, respectively. In this embodiment, when viewed from above, each high-frequency heating coil 28 is sufficiently large to cover one circuit board 11 and is larger than a top surface of a weight 35 described later. Each high-frequency heating coil 28 takes a spiral form in one plane and is shaped like a substantially rectangular plate as a whole. Each high-frequency heating coil 28 is arranged to face the lid member 19, more specifically, the glass plate 22. Each high-frequency heating coil 28 is electrically connected to a high-frequency generator 29 of the soldering apparatus HK, so that the temperature of the coil 28 can be controlled to a predetermined temperature based on measurement result of the temperature sensor 27 installed in the container 17. Each high-frequency heating coil 28 has a cooling channel 30 through which cooling water flows and is connected to a cooling water tank 31 provided in the soldering apparatus HK.

Fig. 4 (a) shows a jig 32 used for soldering and Fig. 4 (b) shows a weight 35 as a pressurizing element. The jig 32 is shaped like a flat plate and has the same dimension as the ceramic substrate 14 on the circuit board 11. The jig 32 is made of a material such as graphite and ceramics. As shown in Fig. 3, the jig 32 is used for positioning a solder sheet 33, the semiconductor devices 12 and the weight 35 with respect to the circuit board 11 at the time of soldering. Thus, a plurality of through holes 34 for positioning are formed on the jig 32 and these through holes 34 are located at sites of the circuit board 11 to which the semiconductor devices 12 are joined. Each through hole 34 has a size corresponding to the respective semiconductor device 12. In this embodiment, since four semiconductor devices 12 are joined onto the circuit board 11, four through holes 34 are formed on the jig 32.

The weight 35 is made of a material which can generate heat due to electromagnetic induction, that is, a material which generates heat due to its electrical resistance when a current occurs by a change in magnetic flux flowing therethrough. In this embodiment, the weight 35 is made of stainless steel. As shown in Fig. 3, the weight 35 is placed immediately upon the semiconductor device 12 at the time of soldering and contacts against the top surface (non-joint surface) of the semiconductor device 12. The weight 35 is used for pressurizing the semiconductor device 12 against the circuit board 11. In this embodiment, the weight 35 is an integrated component manufactured by machining. The weight 35 has a plurality of (four) pressurizing surfaces 35a and the pressurizing surfaces 35a can be inserted into the through holes 34 of the jig 32, respectively, and contact non-joint surfaces (top surfaces) of four semiconductor devices 12, thereby pressurizing the corresponding semiconductor devices 12. Fig. 4 (a) shows a state where the weight 35 is installed at the jig 32 and the weight 35 is represented by a chain double-dashed line.

Next, a method for soldering the semiconductor device 12 using the soldering apparatus HK in this embodiment will be described. A soldering process is a process of a method for manufacturing the semiconductor apparatus (semiconductor module 100). When soldering is performed using the soldering apparatus HK in this embodiment, an object formed by joining six circuit boards 11 to one heat sink 13 (hereinafter referred to as "soldering target") is prepared in advance. That is, the soldering target corresponds to the semiconductor module 100 shown in Fig. 5 except for the semiconductor devices 12.

When soldering is performed, first, the lid member 19 is removed from the body member 18 to open the opening 18a. Then, as shown in Fig. 3, the soldering target is placed on the support base 20 of the body member 18 and positioned with respect to the support base 20. Next, the jig 32 is placed on each circuit board 11 (ceramic substrate 14) of the soldering target, and the solder sheet 33 and the semiconductor device 12 are disposed in each through hole 34 of the jig 32. The solder sheet 33 is disposed between the circuit board 11 (metal plate 15) and the semiconductor devices 12. Then, the weight 35 is placed on the circuit board 11 on which the semiconductor devices 12 are mounted. In this state, the solder sheet 33, the semiconductor devices 12 and the weight 35 are laminated on the circuit board 11 (metal plate 15) in this order from the side of the metal plate 15. The solder sheet 33, the semiconductor devices 12 and the weight 35 are laminated in the vertical direction of the soldering apparatus HK in Fig. 3. The pressurizing surfaces 35a of the weight 35 contact against non-joint surfaces of the corresponding semiconductor devices 12, pressurizing the corresponding semiconductor devices 12.

Next, the lid member 19 is attached to the body member 18 to close the opening 18a so that the closed space S is defined in the container 17. In the state where the soldering target is accommodated in the closed space S (as shown in Fig. 3), each high-frequency heating coil 28 is disposed above the soldering target, more specifically, above the corresponding weight 35. The glass plate 22 attached to the lid member 19 is disposed between each high-frequency heating coil 28 and the soldering target (each weight 35). In this embodiment, the high-frequency heating coil 28 is configured and disposed so as to extend off the region formed by the outline of top surface of the weight 35 when viewed from above. Since the spiral-shaped high-frequency heating coil 28 in this embodiment generates much magnetic flux at its center, it is preferred that the weight 35, in other words, the joint site to the semiconductor device 12 of the circuit board 11 be disposed at the place corresponding to the center of the high-frequency heating coil 28.

Next, the container 17 is evacuated by operating the gas discharge unit 25. Then, nitrogen is supplied into the container 17 by the inert gas supply unit 24 to fill the closed space S with inert gas. After evacuation and supply of nitrogen are repeated a few times, hydrogen is supplied into the container 17 by the reducing gas supply unit 23, thereby putting the closed space S into atmosphere of reducing gas.

Next, the high-frequency generator 29 is activated to pass a high-frequency current through each high-frequency heating coil 28. Thus, high-frequency magnetic flux passing through the weight 35 occurs and an eddy current occurs in the weight 35. As a result, the weight 35 generates heat due to electromagnetic induction and the heat is transmitted from the pressurizing surfaces 35a of the weight 35 to the semiconductor devices 12. The heat generated in the weight 35 is intensively transmitted to each joint site of the circuit board 11 through the pressurizing surfaces 35a of the weight 35 and heats each joint site of the circuit board 11. As a result, the temperature of the heat transmitted to the solder sheet 33 through the semiconductor devices 12 becomes a melting temperature or higher and thus, the solder sheet 33 is melted. Furthermore, since the semiconductor devices 12 are pressed by the weights 35 toward the circuit board 11, the semiconductor devices 12 are not moved by surface tension of the melted solder. Then, when the solder sheet 33 is completely melted, the high-frequency generator 29 is stopped. The temperature of each high-frequency heating coil 28 is controlled based on detection result of the temperature sensor 27 installed in the container 17. According to progress status of the soldering operation, the atmosphere in the container 17 (closed space S) is adjusted, that is, the pressure in the container 17 is increased or decreased.

When the solder sheet 33 is completely melted, cooling gas is supplied into the container 17 by the heat medium supply unit 26. The cooling gas stored in the container 17 flows around the heat sink 13 and cools the soldering target (semiconductor module 100). The melted solder is cooled to a temperature below the melting temperature and solidified, thereby joining the metal plate 15 to the semiconductor devices 12. In this state, the soldering operation is finished and the semiconductor module 100 is completed. Then, the lid member 19 is removed from the body member 18 and the jig 32 and the weight 35 are detached. After that, the semiconductor module 100 is taken out of the container 17. When the semiconductor module 100 is taken out of the container 17, first, the gas in the closed space S is discharged by the gas discharge unit 25.

This embodiment has the following advantages.
(1) The high-frequency heating coil 28 is disposed away from the weight 35 and allows the weight 35 to generate heat. For this reason, even when the plurality of semiconductor devices 12 are soldered to the circuit board 11, the plurality of joint sites can be heated without providing the high-frequency heating coil 28 for each weight 35. At the time of cooling of the melted solder, the high-frequency heating coil 28 can be handled independently from the weight 35 and the circuit board 11. As a result, another semiconductor module 100 can be soldered by using the high-frequency heating coil 28. Accordingly, configuration of the soldering apparatus HK is simplified, resulting in improvement in the efficiency of the soldering operation.
(2) By allowing the weight 35 which presses the semiconductor devices 12 to generate heat to heat the joint sites of the circuit board 11, heat can be transmitted to the joint sites in a concentrated manner. Accordingly, as compared to the case of heating the whole of the circuit board 11 and the container 17, the solder sheet 33 can be heated more efficiently.
(3) The high-frequency heating coils 28 are disposed above the weight 35 placed immediately upon the semiconductor devices 12. Thus, the high-frequency heating coils 28 can transmit heat to the plurality of joint sites of the circuit board 11 in a plane, thereby uniformly heating the plurality of joint sites of the circuit board 11. As a result, for the solder sheet 33 placed on the plurality of joint sites, the end timing as well as the start timing can be made substantially constant, and thus the efficiency of the soldering operation is improved.
(4) The high-frequency heating coils 28 are placed outside of the container 17. For this reason, use of the high-frequency heating coils 28 is not limited except for the heating period in the soldering operation. Thus, if the container 17 opposed to the high-frequency heating coils 28 is replaced immediately after heating of the high-frequency heating coils 28, the next soldering operation can be performed before the solder is cooled, providing the soldering apparatus HK suitable for a production line.
(5) By disposing the high-frequency heating coils 28 outside of the container 17, not inside of the container 17, the capacity of the container 17 can be reduced as much as possible, thereby realizing miniaturization of the container 17. Adjustment of atmosphere includes discharge of air from the container 17 (evacuation), supply and discharge of inert gas (nitrogen gas) and supply and discharge of reducing gas (hydrogen, etc.). For this reason, by making the capacity of the container 17 smaller, time and energy required to discharge air such as energy necessary for operating the vacuum pump 25c is reduced. Also, time and energy required for supply and discharge as well as consumption of supplied gas can be reduced.
(6) The part of the container 17 which faces the high-frequency heating coils 28 (lid member 19 in this embodiment) is formed of the glass plate 22 (electrical insulating material). For this reason, the container 17 itself is prevented from generating heat, and passage of the magnetic flux is allowed to heat the weight 35.
(7) At the time of cooling of the joint sites of the circuit board 11, cooling gas is supplied around the heat sink 13 joined to the circuit board 11. For this reason, the joint sites of the circuit board 11 can be efficiently cooled through the heat sink 13, thereby shortening the cooling time. As a result, time required for the soldering operation is also reduced.
(8) The weight 35 has the plurality of pressurizing surfaces 35a which can contact non-joint surfaces of the plurality of semiconductor devices 12. That is, the weight 35 is constituted as one assembly corresponding to the plurality of semiconductor devices 12. For this reason, since the area which is pressurized by one weight 35 can be increased, the soldering operation is performed in a stable state with less influence of surface tension of the melted solder.
(9) When the plurality of circuit boards 11 are soldered, one high-frequency heating coil 28 is disposed for each circuit board 11 (weight 35) to cause the weight 35 placed on the circuit board 11 to generate heat. For this reason, as compared with the case where one high-frequency heating coil 28 causes the plurality of weights 35 placed on the plurality of circuit board 11, the efficiency is improved.

The above-mentioned embodiment may be modified as follows.

Although the weight 35 is formed as one unit by machining, the weight 35 may be an assembly formed by joining a plurality of parts to each other.

The weight 35 may be provided as separate pieces provided for each semiconductor device 12. For example, in this embodiment, since four semiconductor devices 12 are joined to each circuit board 11, four pieces of weight 35 may be placed immediately upon the semiconductor devices 12.

The weight 35 may be attached to the rear surface of the lid member 19. For example, as represented by the chain double-dashed line in Fig. 3, the weight 35 may be directly attached to the lid member 19 or hung from the lid member 19. In this case, when the opening 18a is closed with the lid member 19, the weight 35 is placed immediately upon the semiconductor devices 12, thereby pressurizing the semiconductor devices 12. When the opening 18a is opened, the weight 35 cancels the pressurizing state of the semiconductor devices 12. With such configuration, the weight 35 can be placed on the semiconductor devices 12 and detached from the semiconductor devices 12 simultaneously with attachment and detachment of the lid member 19, respectively, resulting in the reduction in work processes.

The weight 35 may be made of iron or graphite in place of stainless steel.

The weight 35 may be made of two types of conductor members of different thermal conductivities. For example, the weight 35 may be made of stainless steel and copper. In this case, by disposing copper on the side of the pressurizing surfaces 35a, variation in heating of the weight 35 is reduced and heat is uniformly transmitted to the semiconductor devices 12. Generally, the temperature of the weight 35 becomes higher from the outer side toward the center. However, by disposing the conductor member having good thermal conductivity on the side of the pressurizing surfaces 35a, increase in temperature at the center is promoted, thereby achieving heating of the whole of the pressurizing surfaces 35a in a short time.

The soldering target soldered by the soldering apparatus HK may be a circuit board 11 to which the heat sink 13 is not attached.

The lid member 19 may be detachable type or open/close type with respect to the body member 18.

The part of the lid member 19 which faces the high-frequency heating coils 28 may be made of an electrical insulating material other than glass, such as ceramics or resin. When the strength of the lid member 19 needs to be increased so as to bear the difference in air pressure between the inside and the outside of the container 17, the lid member 19 may be made of a composite material of fiberglass and resin (GFRP: glass fiber reinforced plastic). The lid member 19 may be made of nonmagnetic metal. When the lid member 19 is made of metal, metal having a higher electric resistivity than the weight 35 should be used. The lid member 19 may be made of a composite material of metal and an insulating material.

The high-frequency heating coil 28 may be formed so as to have the same dimension as the outline of the top surface of the weight 35, and may be disposed above the weight 35 so as to correspond to the outline of the top surface of the weight 35.

The high-frequency heating coil 28 may be disposed over the plurality of weights 35 above the plurality of weight 35. In this case, the number of supply channels of the high-frequency current and cooling water to high-frequency heating coil 28 can be reduced, thereby further simplifying configuration of the soldering apparatus HK.

In the production line, the container 17 may be movable and the high-frequency heating coil 28 may be disposed along the route of the weight 35 which moves with the container 17. In this case, the high-frequency heating coil 28 may be shaped so as to meet the moving route or a plurality of high-frequency heating coils 28 are arranged along the moving route. With such configuration, the container 17 can be heated while being moved.

The high-frequency heating coils 28 may be disposed to face the side surface of the weight 35.

The high-frequency heating coils 28 may be disposed in the container 17 (closed space S).

The container 17 may have a tank which is filled with heat medium therein to supply the heat medium from the tank into the container 17 at the time of cooling.

## Claims

1. A soldering apparatus for soldering a semiconductor device to each of a plurality of joint sites of a circuit board, the apparatus comprising:
a sealable container which accommodates the circuit board therein in a state where the semiconductor devices are placed on the plurality of the joint sites of the circuit board with solder;
a pressurizing element made of a conductor material placed immediately upon the semiconductor devices so as to press the semiconductor devices toward the circuit board; and
a high-frequency heating coil disposed away from the pressurizing element, the high-frequency heating coil causing the pressurizing element to generate heat due to electromagnetic induction when a high-frequency current is passed therethrough, thereby heating and melting the solder.

2. The soldering apparatus according to claim 1, wherein the high-frequency heating coil is disposed above the pressurizing element.

3. The soldering apparatus according to claim 1 or 2, wherein the high-frequency heating coil is disposed outside of the container, and a part of the container which faces the high-frequency heating coil is made of a nonmagnetic material.

4. The soldering apparatus according to claim 1 or 2, wherein the high-frequency heating coil is disposed outside of the container, and a part of the container which faces the high-frequency heating coil is made of a material which is nonmagnetic and has a higher electric resistivity than the pressurizing element.

5. The soldering apparatus according to claim 1 or 2, wherein the high-frequency heating coil is disposed outside of the container, and a part of the container which faces the high-frequency heating coil is made of a nonmagnetic electrical insulating material.

6. The soldering apparatus according to any one of claims 1 to 5, wherein a radiator is joined to the circuit board and a supply unit for supplying heat medium to the radiator is connected to the container.

7. The soldering apparatus according to any one of claims 1 to 6, wherein the container has a box-like body member with an opening and a lid member which can open or close the opening,
wherein the pressurizing element is attached to the lid member, the pressurizing element being disposed immediately upon the semiconductor devices to pressurize the semiconductor devices when the opening is closed with the lid member, and cancels the pressurizing state of the semiconductor devices when the opening is opened.

8. The soldering apparatus according to any of one of claims 1 to 7, wherein the pressurizing element has a pressurizing surface which pressurizes the plurality of semiconductor devices simultaneously.

9. A soldering method for soldering a semiconductor device to each of a plurality of joint sites of a circuit board, the method comprising:
accommodating the circuit board in a sealable container;
placing the semiconductor device on each of a plurality of the joint sites of the circuit board with solder;
placing a pressurizing element immediately upon the semiconductor devices to press the semiconductor devices toward the circuit board;
sealing the container in a state where the circuit board on which the semiconductor devices and the pressurizing element are placed is accommodated in the container;
disposing the high-frequency heating coil away from the pressurizing element; and
passing a high-frequency current through the high-frequency heating coil so as to cause the pressurizing element to generate heat due to the electromagnetic induction, thereby heating and melting the solder.

10. The soldering method according to claim 9, further comprising supplying heat medium to a radiator joined to the circuit board after the solder is melted, thereby cooling and solidifying the melted solder.

11. A method for manufacturing a semiconductor apparatus having a circuit board and semiconductor devices soldered to a plurality of joint sites of the circuit board, the method comprising:
accommodating the circuit board in a sealable container;
placing the semiconductor device on each of a plurality of the joint sites of the circuit board with solder;
placing a pressurizing element immediately upon the semiconductor devices to press the semiconductor devices toward the circuit board;
sealing the container in a state where the circuit board on which the semiconductor devices and the pressurizing element are placed is accommodated in the container;
disposing the high-frequency heating coil away from the pressurizing element; and
passing a high-frequency current through the high-frequency heating coil so as to cause pressurizing element to generate heat due to the electromagnetic induction, thereby heating and melting the solder.
